Europäisches Patentamt

European Patent Office

Office européen des brevets

(19)

(11) Veröffentlichungsnummer : **0 316 635 B1**

(12) # EUROPÄISCHE PATENTSCHRIFT

(45) Veröffentlichungstag der Patentschrift :
**21.09.94 Patentblatt 94/38**

(51) Int. Cl.$^5$ : **G01R 15/07, G01R 29/12**

(21) Anmeldenummer : **88117914.7**

(22) Anmeldetag : **27.10.88**

(54) **Faseroptischer Spannungssensor.**

(30) Priorität : **13.11.87 CH 4432/87**

(43) Veröffentlichungstag der Anmeldung :
**24.05.89 Patentblatt 89/21**

(45) Bekanntmachung des Hinweises auf die
Patenterteilung :
**21.09.94 Patentblatt 94/38**

(84) Benannte Vertragsstaaten :
**CH DE FR GB IT LI SE**

(56) Entgegenhaltungen :
**US-A- 3 827 000**
**US-A- 4 477 723**
**US-A- 4 524 322**
**OPTICS AND LASER TECHNOLOGY, Band 9,**
**Nr. 6, Dezember 1977, Seiten 273-283; A.J.RO-**
**GERS: "Optical methods for measurement of**
**voltage and current on powersystems"**

(73) Patentinhaber : **ABB Management AG**
**Haselstrasse 16**
**CH-5401 Baden (CH)**

(72) Erfinder : **Bohnert, Klaus, Dr.**
**Loonstrasse 9**
**CH-5443 Niederrohrdorf (CH)**
Erfinder : **Kirchhofer, Rolf**
**Zentralplatz 2**
**CH-5507 Mellingen (CH)**

(74) Vertreter : **Kaiser, Helmut, Dr. et al**
**ABB Management AG,**
**Abt. TEI - Immaterialgüterrecht**
**CH-5401 Baden (CH)**

EP 0 316 635 B1

## Beschreibung

Technische Gebiet

Die Erfindung betrifft einen faseroptischen Spannungssensor, umfassend mindestens ein faseroptisches, piezoelektrisches Sensorelement, welches eine vorgebbare Richtungskomponente eines lokalen elektrischen Feldes misst.

Stand der Technik

Faseroptische Sensoren dringen in neuerer Zeit in alle Gebiete der Messtechnik vor. Dies hat seinen Grund in der geringen Störempfindlichkeit solcher Sensoren, insbesonder gegenüber elektrischen und magnetischen Störfeldern. Da heute auch die benötigten optischen Komponenten (Glasfasern, Laser, Fotodioden etc.) mit hoher Qualität zu konkurrenzfähigen Preisen zu haben sind, sind faseroptische Sensoren auch in wirtschaftlicher Hinsicht interessant geworden. Zum Messen von elektrischen Feldstärken und Potentialdifferenzen werden mit Vorteil piezoelektrische Sensorelemente eingesetzt. Solche piezoelektrische Sensorelemente verwenden den inversen Piezoeffekt, um eine zur elektrischen Feldstärke proportionale Längenänderung einer Glasfaser zu bewirken. Diese Längenänderung wird dann auf interferometrische Weise gemessen.

In der Druckschrift "Optical-fiber copolymer-film electric-field-sensor", M.D. Mermelstein, Appl. Optics 22, 1006 (1983), wird eine Glasfaser in einen Körper aus PVDF (Polyvinylidenfluorid) eingebettet. Das Ganze wird in ein elektrisches Feld gebracht und eine Längenänderung der Glasfaser, welche proportional zur elektrischen Feldstärke ist, mit einem Mach-Zehnder-Interferometer gemessen. Bei gegebener geometrischer Anordnung, d.h. bei gegebener Feldverteilung, lässt sich z.B. auch eine Potentialdifferenz messen, da in diesem Fall die Potentialdifferenz z.B. zwichen zwei Platten eines Kondensators und ein ideale elektrische Feldstärke an einem gegebenen Ort im Raum direkt zusammenhängen.

In der Druckschrift "Fiber-optic Fabry-Perot interferometer ans its Sensor Applications", T. Yoshino et al., IEEE J. of Quant. Elektr. QE-18, 1624 (1983), wird eine Spannung so gemessen, dass im eine scheibenförmige piezoelektrische Keramik (PZT) ein faseroptisches Fabry-Perot-Interferometer gewickelt wird, an die PZT eine Spannung angelegt wird und die Transmission (resp. Reflexion) des faseroptische Fabry-Perot-Interferometers ausgewertet wird.

Aus der schweizerischen Patentanmeldung CH 4322/87 bzw. der nicht vorveröffentlichten und damit unter Art 54(3) EPÜ fallenden Europäischen Patentanmeldung EP-A-0 316 619 ist schliesslich ein piezoelektrisches Sensorelement bekannt. Mit einem solchen Sensor lässt sich eine bestimmte, aber frei vorgebbare Richtungskomponente eines lokalen elektrischen Feldes messen. Auch mit diesem Sensor lässt sich bei gegebener Feldverteilung eine Potentialdifferenz bestimmen.

Mit einem solchen piezoelektrischen Sensorelement kann bei gegebener Feldverteilung (Elektrode, Leiter, Isolatoren) via Messung einer elektrischen Feldstärke eine Potentialdifferenz ermittelt werden. Der grundsätzliche Nachteil einer solchen Messmethode liegt jedoch darin, dass sie nur für eine feste, sich nicht ändernde Anordnung geeignet ist. Anders gesagt muss für jede Feldverteilung die Messanordnung neu geeicht werden.

Einen anderen Weg beschreitet A.J. Rogers in "Optical methods for measurement of voltage and current on power systems", Optics and Laser Technology, December 1977. Statt des piezoelektrischen Effektes wird hier der optoelektrische Effekt zur Spannungsmessung verwendet. Zu diesem Zweck wird das Linienintegral zwischen zwei Raumpunkten durch ein endliche Summe angenähert. Die Messanordnung weist demgemäss eine Anzahl Quarz-Blöcke auf, welche durch Glasfaser-Abschnitte verbunden sind. Die Messung erfolgt über den ganzen Integrationsweg optisch und die einzelnen Sensorelemente sind untereinander optisch gekoppelt.

## Darstellung der Erfindung

Aufgabe der vorliegenden Erfindung ist es nun, einen faseroptischen Spannungssensor der eingangs genannten Art anzugeben, mit welchem sich unabhängig von einer bestimmten Feldverteilung eine Potentialdifferenz zwischen zwei frei wählbaren Raumpunkten messen lässt.

Diese Aufgabe wird durch die Merkmale des ersten Anspruchs gelöst.

Kern der Erfindung ist es also, das Linienintegral eines Weges zwischen zwei Raumpunkten durch eine endliche Summen von Streckenelementen anzunähern. Aus diesem Grunde besteht der Spannungssensor aus mehreren Sensorelementen, welche untereinander mechanisch gekoppelt sind. Jedes Sensorelement ist aus einem Körper piezoelektrischen Materials aufgebaut, auf welchem eine durchgehende Glasfaser so angebracht ist, dass die bestimmte vorgegebene Richtungskomponente des elektrischen Feldes eine Längenänderung der Faser bewirkt. Durch die Längenänderung der Faser, hervorgerufen durch die lokale Feldstärke, besitzt jedes Sensorelement einen Verstärkungsfaktor, welcher proportional zu einer Länge des ihm zugeordneten Streckenelements ist.

Wenn alle Steckenelemente $\underline{s}_i$ dieselbe Länge haben, können die piezoelektrischen Sensorelemente identisch sein. Dies entspricht einer besonders vorteilhaften Ausführungsform der Erfindung.

Weiter bevorzugte Ausführungsformen der Erfindung gehen aus den entsprechenden abhängigen Ansprüchen hervor.

## Kurze Beschreibung der Zeichnung

Nachfolgend wird die Erfindung anhand von Ausführungsbeispielen und im Zusammenhang mit der Zeichnung näher erläutert. Es zeigen:

Fig. 1     eine Darstellung des Prinzips des erfindungsgemässen faseroptischen Spannunssensors;

Fig. 2     einen faseroptischen Spannungssensor mit scheibenförmigen, piezoelektrischen Sensorelementen;

Fig. 3     einen faseroptischen Spannungssensor mit plattenförmigen, piezoelektrische Sensorelementen, welche eine parallel zu einer jeweiligen Plattenlängsrichtung liegende Richtungskomponente einer lokalen Feldstärke messen; und

Fig. 4     einen faseroptischen Spannungssensor mit plattenförmigen, piezoelektrische Sensorelementen, welche eine zu einer jeweiligen Plattennormalen parallel liegende Richtungskomponente einer lokalen Feldstärke messen.

Wege zur Ausführung der Erfindung

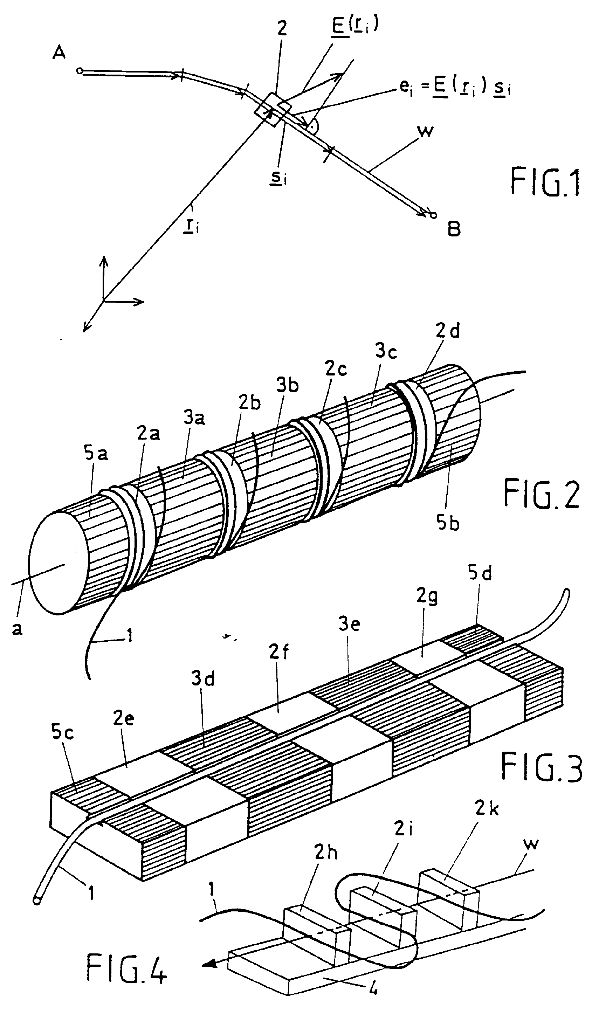

Fig. 1 zeigt eine Darstellung des Prinzips, auf welchem die Erfindung beruht.

Bekanntlich ist eine Potentialdifferenz V zwischen zwei Raumpunkten A,B in einer ortsabhängigen elektrischen Feldverteilung $\underline{E}(\underline{r})$, wobei $\underline{r}$ einen Ortsvektor bezeichnet, gegeben durch ein Linienintegral L

$$V = L = \int_w \underline{E}(\underline{r})\,\underline{dw} \qquad\qquad (I)$$

entlang eines die beiden Raumpunkte A, B verbinden Intergrationsweges w. Der Kern der Erfindung liegt nun darin, den Integrationsweges w als Polygonzug zu wählen, bestehend aus einer gegebenen Anzahl n von Streckenelementen $\underline{s}_i$ ($i=1..n$) und die elektrische Feldverteilung $\underline{E}(\underline{r})$ entlang eines jeden Strekkenelementes $\underline{s}_i$ in Betrag und Richtung als konstant anzunehmen, sodass das Linienintegral L durch eine Summe S approximiert werden kann:

$$L \approx S = \sum_{i=1}^{n} \underline{E}(\underline{r}_i)\,\underline{s}_i \qquad\qquad (II)$$

Auf jedem Streckenelement $\underline{s}_j$ wird eine Stützstelle $\underline{r}_j$ festgelegt. An jeder Stützstelle $\underline{r}_j$ ist ein piezoelektrisches Sensorelement 2 angeordnet. Dieses bestimmt einen Summanden $e_i$ als Skalarprodukt einer lokalen Feldstärke $\underline{E}(\underline{r}_j)$ mit dem entsprechenden Streckenelement $\underline{s}_i$.

Das Sensorelement (2) muss so ausgerichtet sein, dass es eine Richtungskomponente der lokalen Feldstärke $\underline{E}(\underline{r}_j)$ misst, welche parallel zum ihm zugeordneten Streckenelement $\underline{s}_j$ liegt. Zudem muss es einen Verstärkungsfaktor besitzen, welcher proportional zu einer Länge des ihm zugeordneten Streckenelementes $\underline{s}_i$ ist.

Unter dem Verstärkungsfaktor eines faseroptischen, piezoelektrischen Sensorelementes ist eine Aenderung der Länge einer Glasfaser zu verstehen, die durch eine gegebene lokale Feldstärke hervorgerufen wird. D.h. ein piezoelektrisches Sensorelement mit einem grossen Verstärkungsfaktor erzeugt bei gegebener lokaler Feldstärke eine grosse Aenderung der Länge der Glasfaser.

Der faseroptische Spannungssensor bestimmt die Potentialdifferenz V nur näherungsweise. Seine Messgenauigkeit hängt im wesentlichen davon ab, wie rasch sich die Feldverteilung $\underline{E}(\underline{r})$ in Betrag und Richtung (bezogen auf den Intergrationsweg w) von einer Stützstelle $\underline{r}_j$ zur nächsten $\underline{r}_j+_1$ ändert. Je langsamer sich die elektrische Feldverteilung $\underline{E}(\underline{r})$ ändert, desto grösser ist die Messgenauigkeit.

3

In der Praxis wird der intergrationsweg w meistens eine mehr oder weniger gerade Linie sein. Die elektrische Feldverteilung $\underline{E}(\underline{r})$ soll sich dann im Vergleich zum Abstand von zwei benachbarten Stützstellen $\underline{r}_i$, $\underline{r}_i+_1$, oder im Vergleich zur Länge der Streckenelemente $\underline{s}_i$, langsam ändern.

Der Schutzumfang der geänderten Ansprüche betrifft nur jene der in dieser Offenbarung genannten Materialien, welche die Messung einer bestimmten, vorgebbaren Richtungskomponente eines elektrischen Felches ermöglichen. Die im weiteren Verlauf der Beschreibung genannten Materialien dienen nur dem technologischen Hintergrundwissen.

Fig. 2 zeigt ein erstes Ausführungsbeispiel der Erfindung, bei welchem der faseroptische Spannungssensor einen zylinderförmigen Körper besitzt. Er umfasst eine Glasfaser 1, vier richtungsempfindliche piezoelektrische Sensorenelemente 2a,2b,2c, 2d, drei Zwischenstücke 3a,3b,3c und zwei Endstücke 5a,5b.

Die vier piezoelektrischen Sensorenelemente 2a,2b,2c,2d sind in diesem Ausführungsbeispiel identisch. Sie entsprechen z.B. einer in der schweizerischen Patentanmeldung CH 4322/87 beschriebenen Ausführungsform. Sie haben die Form einer Scheibe und bestehen z.B. aus PVDF (Polyvinylidenfluorid), welches in einer kristallographischen Z-Richtung elektrisch gepolt und in einer kristallographischen Y-Richtung mechanisch gereckt ist. Eine Kristallographische Z-Richtung liegt parallel zu einer Scheibennormalen. X-Richtung und Y-Richtung liegen beide senkrecht dazu, und somit senkrecht zu einer Achse a des zylinderförmigen Körpers.

Zwischen je zwei Scheiben aus PVDF befindet sich jeweils ein Zwischenstück 3a,3b,3c. Die Glasfaser 1 wird um diesen zylinderförmigen Körper herumgewickelt, wobei jede Scheibe gleichviele Wicklungen aufweisen muss. In diesem Ausführungsbeispiel ist sie jeweils zweimal um jede Scheibe geführt. Die beiden Endstücke bilden jeweils den Abschluss des zylinderförmigen Körpers, da die Zahl der Wicklungen den Verstärkungsfaktor der piezoelektrischen Sensorelemente 2a,2b,2c,2d festlegt.

Jedes piezoelektrische Sensorenelement 2a, 2b,2c,2d misst eine Richtungskomponente der elektrischen Feldes, welche parallel zur Scheibennormalen und somit parallel zur Achse a liegt. Offensichtlich stellt die Achse a den Integrationsweg w dar. Den beiden Raumpunkten A,B der Fig. 1 entsprechend die beiden Endflächen des zylinderförmigen Körpers oder, genau gesagt die Durchstosspunkte der Achse a mit den Endflächen. Die Endstücke 5a,5b sind allein dazu da, den Integrationsweg genau zu defi nieren. Dementsprechend müssen sie halb so lang wie die Zwischenstücke 3a,3b,3c sein.

Die Zwischenstücke 3a,3b,3c sind in diesem Ausführungsbeispiel alle gleich lang und aus einem nicht piezoelektrischen Material, z.B. aus nicht elektrisch gepoltem PVDF oder aus Nylon. Es ist nämlich wichtig, dass die Zwischenstücke 3a,3b,3c nicht wie die piezoelektrischen Sensorelemente 2a,2b,2c,2d durch die zu messende und integrierende elektrische Feldverteilung $\underline{E}(\underline{r})$ eine Aenderung der Länge der Glasfaser 1 bewirken. Die Länge der Zwischenstücke 3a,3b,3c soll so gewählt werden, dass die gewünschte Messgenauigkeit erreicht werden kann.

In einer bevorzugten Ausführungsform der Erfindung sind die scheibenförmigen piezoelektrischen Sensorelemente ohne jegliche Zwischenstücke auf einer gemeinsamen Achse direkt nebeneinander angeordnet. In diesem sogenannten quasi-kontinuierlichen Fall muss eine Glasfaser mit einer konstanten Anzahl von Wicklungen pro Länge des zylinderförmigen Körpers aufgewickelt werden. Eine dem Streckenelement $\underline{s}_i$ und damit dem Verstärkungsfaktor entsprechende Grösse ist dann der Abstand zweier benachbarter Wicklungen der Glasfaser. Ob der zylinderförmige Körper aus mehreren piezoelektrischen Scheiben zusammengesetzt ist, oder ob er aus einem einzigen zusammenhängenden Material besteht, ist allein durch technologische Ueberlegungen bedingt und für die Erfindung unwesentlich.

Die piezoelektrischen Sensorelemente 2a,2b,2c,2d und die Zwischenstücke 3a,3b,3c sollen so zusammengefügt werden, dass sie sich nicht gegenseitig in ihrer entsprechenden Funktion stören. Sie können z.B. mit einer Ausbohrung versehen und auf einer Spindel aufgereiht sein, wo sie zwischen zwei Muttern eingeklemmt werden können.

Für gewisse Anwendungen kann es von Vorteil sein, wenn sich der faseroptische Spannungssensor entlang seiner Achse a biegen lässt. In solchen Fällen werden die Zwischenstücke 3a,3b,3c bevorzugterweise mechanisch flexibel ausgebildet sein. Sie können entweder elastisch oder plastisch deformierbar sein, dürfen ihre Länge aber nicht wesentlich ändern. Ebenso sollte sich die Richtung der Scheibennormalen von einem piezoelektrischen Sensorelement zum nächsten nicht allzustark ändern.

Bekanntlich wird durch den inversen piezoelektrischen Effekt mittels der piezoelektrischen Scheiben die Länge der Glasfaser 1 geändert, und zwar proportional zu der zur Achse a parallel liegenden Richtungskomponente der lokalen Feldstärke $\underline{E}(\underline{r}_i)$. Die gesamte Aenderung der Länge der Glasfaser 1 ist proportional zur Spannung, welche zwischen den Enden des faseroptischen Spannungssensors, d.h. zwischen den beiden Raumpunkten A,B herrscht. Sie kann z.B. mit einem Mach-Zehnder-Interferometer gemessen werden. Die Glasfaser 1 bildet dann einen Arm des Mach-Zehnder-Interferometers. Einzelheiten zu dieser bevorzugten Anordnung können der bereits zitierten schweizerischen Patentanmeldung CH 4322/87 oder der eingangs genannten Druckschrift von M.D. Mermelstein entnommen werden.

Es versteht sich, dass die Erfindung nicht auf faseroptische Spannungssensoren mit vier piezoelektrischen Sensorelementen beschränkt ist. Die Anzahl der piezoelektrischen Sensorelemente soll vielmehr auf die jeweiligen Bedürfnisse abgestimmt sein. Wie sich die soeben beschriebene Ausführungsform der Erfindung auf faseroptische Spannungssensoren mit einer beliebig gewählten Anzahl von piezoelektrische Sensorelementen erweitern lässt, bedarf keinerlei weiterer Erläuterungen.

Haben die einzelnen Streckenelemente $s_j$ nicht alle dieselbe Länge, so müssen die piezoelektrischen Sensorelemente auch unterschiedliche Verstärkungsfaktoren aufweisen. Wie bereits gesagt, muss der Verstärkungsfaktor eines piezoelektrischen Sensorelementes entsprechend der Länge des ihm zugeordneten Streckenelementes $s_1$ gewählt werden. Beim beschriebenen Beispiel, wo die einzelnen piezoelektrischen Sensorelemente 2a, 2b,2c,2d, d.h. Scheiben, alle dieselben Körperabmessungen haben, ist der Verstärkungsfaktor gegeben durch die Anzahl Wicklungen pro Scheibe. Eine piezoelektrisches Sensorelement, dessen Streckenelement $s_j$ z.B. doppelt so lang ist wie ein benachbartes, muss demzufolge eine doppelt so grosse Wikklungszahl wie das benachbarte besitzen. Das Verhältnis der Wicklungszahlen ist in diesem Fall entsprechend dem Verhältnis der Längen der zugeordneten Streckenelemente $s_j$ festzusetzen.

Es ist aber auch denkbar, den Verstärkungsfaktor durch andere Grössen wie z.B. den Radius der Scheibe vorzugeben.

Fig. 3 zeigt einen faseroptischen Spannungssensor mit plattenförmigen, piezoelektrischen Sensorenelementen. Bei diesem zweiten Ausführungsbeispiel umfasst der faseroptische Spannungssensor, analog zu Fig. 2, eine Glasfaser 1, drei identische, piezoelektrische Sensorenelemente 2e,2f,2g, zwei Endstücke 5c,5d und zwei Zwischenstücke 3d,3e. Im Unterschied zum ersten Ausführungsbeispiel haben die piezoelektrischen Sensorenelemente 2e,2f,2g die Form einer Platte. Die Glasfaser 1 ist in einer Plattenlängsrichtung auf einer Hauptfläche der Platte befestigt. Eine kristallographische Orientierung des piezoelektrischen Materials der Platte ist so gewählt, dass eine Richtungskomponente der lokalen Feldstärke gemessen wird, welche parallel zu einer Plattenlängsrichtung und somit parallel zur Glasfaser 1 liegt.

Besteht das piezoelektrische Sensorenelement 2e,2f,2g, d.h. die Platte, z.B. aus $\alpha$-Quarz, so muss eine kristallographische X-Richtung parallel zur Glasfaser 1 liegen. Die Orientierung einer kristallographischen Y- und Z-Richtung ist beliebig. Dieses Beispiel stellt nur eine von vielen Möglichkeiten dar, ein piezoelektrisches Sensorelement 2e,2f,2g zu gestalten. Für eine ausführliche Zusammenstellung aller Möglichkeiten wird wiederum auf die schweizerische Patentanmeldung CH 4322/87 verwiesen.

Ueber die Zwischenstücke 3d,3e und die Endstücke 5c,5d kann dasselbe gesagt werden wie im Ausführungsbeispiel gemäss Fig. 2. Insbesondere sollen sie alle aus einem nicht piezoelektrischen Material bestehen. Die beiden Endstücke 5c,5d sind halb so lang wie die Zwischenstücke 3d,3e. Dies hat seinen Grund darin, dass die piezoelektrische Sensorelemente 2e,2f,2g identisch sind, oder anders gesagt, dass die Streckenelement $s_j$ alle gleich lang sind.

Einer Erweiterung der beschriebenen Ausführungsform auf einen faseroptischen Spannungssenor mit einer beliebig gewählten Anzahl von piezoelektrischen Sensorelementen stehen keinerlei Schwierigkeiten entgegen. Der Verstärkungsfaktor eines piezoelektrischen Sensorelementes 2e,2f,2g ist in diesem Beispiel bestimmt durch eine Länge der Platte. Die Länge der Platte ist demzufolge im Verhältnis zur Länge des dem entsprechenden piezoelektrischen Sensorelement 2e,2f,2g zugeordneten Strekkenelementes $s_j$ zu wählen.

Die Zwischenstücke 3d,3e sind nicht wesentlich. Grundsätzlich genügt es, an einer Glasfaser 1 in gegebenen Abständen eine Mehrzahl von piezoelektrischen Sensorelementen anzubringen. Es ist dann allerdings zu beachten, dass Richtung und Abstände der piezoelektrischen Sensorelemente im Raum so sind, dass die Approximation des Linienintegrals L noch aussagekräftig ist. In der Praxis wird es darauf hinauslaufen, die Glasfaser 1 gestreckt zu halten. Der Integrationsweg w fällt dann mit der Glasfaser 1 zusammen.

Auch hier sei darauf verwiesen, dass sich die piezoelektrischen Sensorelemente auch direkt aneinanderfügen lassen, analog zum bereits beschriebenen sogenannten quasi-kontinuierlichen Fall des zylinderförmigen faseroptischen Spannungssensors.

Fig. 4 zeigt eine weitere Ausführungsform der Erfindung. Sie umfasst eine Glasfaser 1, piezoelektrische Sensorelemente 2h, 2i,2k und einen Träger 4. Wiederum haben die piezoelektrischen Sensorelemente 2h,2i,2k die Form einer Platte. Eine kristallographische Orientierung ist aber so gewählt, dass eine Richtungskomponente einer lokalen Feldstärke $\underline{E}(\underline{r}_j)$ gemessen wird, welche parallel zu einer jeweiligen Plattennormalen liegt. In der Fig. 4 ist auch der Integrationsweg w dargestellt. Bei jeder Platte verläuft er parallel zur jeweiligen Plattnormalen.

Aus der Fülle der in der bereits genannten schweizerischen Patentanmeldung CH 4322/87 beschriebenen Varianten für ein piezoelektrisches Sensorelement sei wiederum als Beispiel eine herausgegriffen. Wenn die Platte beispielsweise aus einer piezoelektrischen Keramik (PZT) besteht, dann muss eine kristallographische Z-Richtung parallel zur Plattennormalen liegen. Die Orientierung von kristallographischer X- and Z-Richtung ist beliebig.

Auf dem Träger 4 sind die piezoelektrischen Sensorelemente 2h,2i,2k gemäss einer bevorzugten Ausführungsform der Erfinadung äquidistant zueinander angebracht. Da der Träger 4 eigentlich die selbe Funktion hat wie die Zwischenstücke bei den oben beschriebenen Ausführungsbeispielen, sollte auch er aus einem nicht piezoelektrischen material bestehen. Da die Glasfaser 1 zwischen den einzelnen piezoelektrischen Sensorelementen kleine Schleifen hat, können sich mechanische Verformungen des Trägers 4 nicht so auswirken, dass sich die Länge der Glasfaser ändert. Der Träger 4 besteht in diesem Ausführungsbeispiel mit Vorteil aus einem elastisch verformbaren Material.

In den Ausführungsbeispielen gemäss Fig. 3 oder Fig. 4 kann die Glasfaser 1 z.B. in der Weise auf der Platte befestigt sein, dass sie in einer auf einer Hauptfläche der Platte angebrachten Nut mit einem Klebstoff eingegossen wird.

Die Merkmale der Erfindung und ihre bevorzugten Ausführungsformen weisen weit über die beschriebenen drei Ausführungsbeispiele hinaus. Die bereits mehrfach genannte schweizerische Patentanmeldung CH 4322/87 offenbart in grundlegender Weise die Kennzeichen piezoelektrischer Sensorelemente. Alle dort beschriebenen Ausführungsbeispiele können bei der vorliegenden Erfindung angewendet werden. Insbesondere ergibt sich, dass die beispielshaft genannten Materialien wie PVDF, Lithiumniobat ($LiNbO_3$), PZT und $\alpha$-Quarz für alle drei beschriebenen Ausführungsbeispiele verwendet werden können.

Bei einer Ausführungsform gemäss Fig. 3 kann ein gemeinsamer Träger (siehe Fig. 4) die Funktion der Zwischenstück 3d,3e übernehmen. Umgekehrt kann der Träger 4 bei einer Ausführungsform gemäss Fig. 4 durch einzelne Zwischenstücke (siehe Fig. 2 und 3) ersetzt werden.

Eine Aenderung der Länge der Glasfaser 1 kann grundsätzlich mit jedem interferometrischen Messverfahren festgestellt werden. Neben der Messung mit einem Mach-Zehnder-Interferometer eignet sich insbesondere auch die Messung mit einem faseroptischen Fabry-Perot-Interferometer.

Abschliessend kann gesagt werden, dass mit der Erfindung ein faseroptischer Spannungssensor zum Messen von Potentialdifferenzen geschaffen worden ist, welcher vielseitig anwendbar, problemlos einzusetzen und unempfindlich gegen Störungen ist.

**Patentansprüche**

1.  Faseroptischer Spannungssensor, umfassend
    a) mehrere Sensorelemente (2, 2a, 2b, ...), welche eine vorgegebene Richtungskomponente einer lokalen Feldstärke ($\underline{E}(\underline{r}_i)$) messen, wobei die Sensorelemente seriell angeordnet sind und jedes Sensorelement (2, 2a, 2b, ...) jeweils die bestimmte Richtungskomponente der lokalen Feldstärke ($\underline{E}(\underline{r}_i)$) misst, welche parallel zu einem dem Sensorelement zugeordneten Streckenelement ($\underline{s}_i$) liegt, wobei die Streckenelemente ($\underline{s}_i$) insgesamt einen die beiden Enden des faseroptischen Spannungssensors verbindenden Integrationsweg (w) bilden;
    wobei
    b) jedes Sensorelement (2, 2a, 2b, ...) einen Körper aus piezoelektrischem Material umfasst, auf welchem eine durchgehende Glasfaser (1) auf einer Oberfläche des Sensorelementes (2, 2a, 2b, ...) in einem gegebenen Längenabschnitt angebracht ist;
    c) die Sensorelemente (2, 2a, 2b, ...) untereinander mechanisch gekoppelt sind;
    d) die Glasfaser (1) so auf der Oberfläche des piezoelektrischen Körpers angebracht ist, dass nur eine durch die vorgegebene Richtungskomponente hervorgerufene Dimensionsänderung des piezoelektrischen Körpers eine Längenänderung der Faser (1) bewirkt; und
    e) jedes Sensorelement (2, 2a, 2b, ...) einen Verstärkungsfaktor besitzt, welcher proportional zu einer Länge des ihm zugeordneten Streckenelementes ($\underline{s}_i$) ist, wobei der Verstärkungsfaktor der durch die Dimensionsänderung des piezoelektrischen Körpers hervorgerufenen Längenänderung der Glasfaser (1) entspricht.

2.  Faseroptischer Spannungssensor nach Anspruch 1, dadurch gekennzeichnet, dass die einzelnen Streckenelemente ($\underline{s}i$) des Integrationsweges (w) gleich lang sind.

3.  Faseroptischer Spannungssensor nach Anspruch 1, dadurch gekennzeichnet, dass die piezoelektrischen Sensorelemente (2, 2a, 2b, ...) durch nicht-piezoelektrische Zwischenstücke (3a, 3b, ...) verbunden sind, welche der mechanischen Kopplung der Sensorelemente (2, 2a, 2b, ...) dienen.

4.  Faseroptischer Spannungssensor nach Anspruch 1, dadurch gekennzeichnet, dass
    a) die piezoelektrischen Sensorelemente (2a, 2b, ...) scheibenförmig sind,

b) und eine Richtungskomponente der lokalen Feldstärke ($\underline{E}(r_i)$) messen, welche parallel zu Scheibennormalen liegt.

5. Faseroptischer Spannungssensor nach Anspruch 1, dadurch gekennzeichnet, dass die Sensorelemente (2e, 2f, 2g) plattenförmig sind und eine Richtungskomponente der lokalen Feldstärke ($\underline{E}(r_i)$) messen, welche parallel zu einer jeweiligen Plattenlängsrichtung liegt.

6. Faseroptischer Spannungssensor nach Anspruch 3, dadurch gekennzeichnet, dass die piezoelektrischen Sensorelemente (2h, 2i, 2k) plattenförmig sind und eine Richtungskomponente der lokalen Feldstärke ($\underline{E}(r_i)$) messen, welche parallel zu einer jeweiligen Plattennormalen liegt.

7. Faseroptischer Spannungssensor nach den Ansprüchen 3 und 5 oder den Ansprüchen 1, 3 und 4, dadurch gekennzeichnet, dass die Zwischenstücke (3a, 3b, ...) mechanisch flexibel sind.

8. Faseroptischer Spannungssensor nach Anspruch 6, dadurch gekennzeichnet, dass die piezoelektrischen Sensorelemente (2h, 2i, 2k) auf einem gemeinsamen nicht piezoelektrischen Träger angeordnet sind.

9. Faseroptischer Spannungssensor nach den Ansprüchen 2 und 4, dadurch gekennzeichnet, dass die Sensorelemente in einem zylinderförmigen Körper integriert sind, indem ein oder mehrere identische, scheibenförmige piezoelektrische Sensorelemente ohne Zwischenstücke (3a, 3b, ...) auf einer gemeinsamen Achse angeordnet sind.

10. Faseroptischer Spannungssensor nach Anspruch 5, dadurch gekennzeichnet, dass die piezoelektrischen Sensorlemente (2e,2f,2g) ohne jegliche Zwischenstücke aneinandergefügt sind.

## Claims

1. Fibre-optic voltage sensor, comprising
   a) several sensor elements (2, 2a, 2b,...) which measure a predetermined directional component of a local field strength ($\underline{E}(r_i)$), the sensor elements being arranged serially and each sensor element (2, 2a, 2b,...) respectively measuring the particular directional component of the local field strength ($\underline{E}(r_i)$), which component lies parallel to a path element ($\underline{s}_i$) assigned to the sensor element, the path elements ($\underline{s}_i$) as a whole forming a path of integration (w) connecting the two ends of the fibre-optic voltage sensor;
   b) each sensor element (2, 2a, 2b,...) comprising a body of piezoelectric material on which a continuous optical fibre (1) is mounted on a surface of the sensor element (2, 2a, 2b,...) in a given length section;
   c) the sensor elements (2, 2a, 2b,...) being connected to one another mechanically;
   d) the optical fibre (1) being mounted on the surface of the piezoelectric body in such a way that only a change in dimension of the piezoelectric body which is caused by the predetermined directional component produces a change in length of the fibre (1); and
   e) each sensor element (2, 2a, 2b,...) having a gain which is proportional to a length of the path element ($\underline{s}_i$) assigned to it, the gain corresponding to the change in length of the optical fibre (1) caused by the change in dimension of the piezoelectric body.

2. Fibre-optic voltage sensor according to Claim 1, characterized in that the individual path elements ($\underline{s}i$) of the path of integration (w) are of the same length.

3. Fibre-optic voltage sensor according to Claim 1, characterized in that the piezoelectric sensor elements (2, 2a, 2b,...) are connected by non-piezoelectric spacers (3a, 3b,...) which serve to couple mechanically the sensor elements (2, 2a, 2b,...).

4. Fibre-optic voltage sensor according to Claim 1, characterized in that
   a) the piezoelectric sensor elements (2a, 2b,...) are disc-shaped,
   b) and measure a directional component of the local field strength ($\underline{E}(ri)$)[sic], which lies parallel to the disc normal.

5. Fibre-optic voltage sensor according to Claim 1, characterized in that the sensor elements (2e, 2f, 2g) are plate-shaped and measure a directional component of the local field strength ($\underline{E}(r_i)$) [sic], which lies

parallel to a respective longitudinal plate direction.

6. Fibre-optic voltage sensor according to Claim 3, characterized in that the piezoelectric sensor elements (2h, 2i, 2k) are plate-shaped and measure a directional component of the local field strength ($\underline{E}(\underline{r}i)$) [sic], which lies parallel to a respective plate normal.

7. Fibre-optic voltage sensor according to Claims 3 and 5, or Claims 1, 3 and 4, characterized in that the spacers (3a, 3b,...) are mechanically flexible.

8. Fibre-optic voltage sensor according to Claim 6, characterized in that the piezoelectric sensor elements (2h, 2i, 2k) are arranged on a common non-piezoelectric carrier.

9. Fibre-optic voltage sensor according to Claims 2 and 4, characterized in that the sensor elements are integrated in a cylindrical body by arranging one or more than one identical, disc-shaped piezoelectric sensor elements on a common axis without spacers (3a, 3b,...).

10. Fibre-optic voltage sensor according to Claim 5, characterized in that the piezoelectric sensor elements (2e, 2f, 2g) are abutted without any spacers.


**Revendications**

1. Capteur de tension à fibre optique comprenant
   a) plusieurs éléments de détection (2, 2a, 2b,...) qui mesurent une composante directionnelle prédéterminée d'une force de champ local ($\underline{E}(\underline{r}_i)$), les éléments de détection étant disposés sériellement et chaque élément de détection (2, 2a, 2b,...) mesurant respectivement la composante directionnelle particulière de la force de champ local ($\underline{E}(\underline{r}_i)$), cette composante se situant parallèlement à un élément de chemin ($\underline{s}_i$) assigné à l'élément de détection, les éléments de chemin ($\underline{s}_i$) formant dans leur ensemble un chemin d'intégration (w) connectant les deux extrémités du capteur de tension à fibre optique;
   dans lequel
   b) chaque élément de détection (2, 2a, 2b,...) comprend un corps de matière piézo-électrique sur lequel une fibre optique continue (1) est montée sur une surface de l'élément de détection (2, 2a, 2b,...) dans une section de longueur donnée;
   c) les éléments de détection (2, 2a, 2b,...) sont couplés les uns aux autres mécaniquement;
   d) la fibre optique (1) est montée sur la surface du corps piézo-électrique de telle sorte que seul un changement de dimension du corps piézo-électrique causé par la composante directionnelle prédéterminée produise un changement de longueur de la fibre (1); et
   e) chaque élément de détection (2, 2a, 2b,...) a un gain qui est proportionnel à une longueur de l'élément de chemin ($\underline{s}_i$) qui lui est assigné, le gain correspondant au changement de longueur de la fibre optique (1) causé par le changement de dimension du corps piézo-électrique.

2. Capteur de tension à fibre optique selon la revendication 1, caractérisé en ce que les éléments de chemin individuels ($\underline{s}_i$) du chemin d'intégration (w) sont de la même longueur.

3. Capteur de tension à fibre optique selon la revendication 1, caractérisé en ce que les éléments de détection piézo-électriques (2, 2a, 2b,...) sont connectés par des pièces d'écartement non piézo-électriques (3a, 3b,...) qui servent à coupler mécaniquement les éléments de détection (2, 2a, 2b,...).

4. Capteur de tension à fibre optique selon la revendication 1, caractérisé en ce que
   a) les éléments de détection piézo-électriques (2a, 2b,...) ont la forme de disques,
   b) et mesurent une composante directionnelle de la force de champ local ($\underline{E}(\underline{r}_i)$), qui se situe parallèlement à la normale de disque.

5. Capteur de tension à fibre optique selon la revendication 1, caractérisé en ce que les éléments de détection (2e, 2f, 2g) ont la forme de plaques et mesurent une composante directionnelle de la force de champ local ($\underline{E}(\underline{r}_i)$), qui se situe parallèlement à une direction longitudinale de plaque respective.

6. Capteur de tension à fibre optique selon la revendication 3, caractérisé en ce que les éléments de détection piézo-électriques (2h, 2i, 2k) ont la forme de plaques et mesurent une composante directionnelle de la force de champ local ($\underline{E}(\underline{r}_j)$), qui se situe parallèlement à une normale de plaque respective.

7. Capteur de tension à fibre optique selon les revendications 3 et 5, ou les revendications 1, 3 et 4, caractérisé en ce que les pièces d'écartement (3a, 3b, ...) sont mécaniquement souples.

8. Capteur de tension à fibre optique selon la revendication 6, caractérisé en ce que les éléments de détection piézo-électriques (2h, 2i, 2k) sont disposés sur un support commun non piézo-électrique.

9. Capteur de tension à fibre optique selon les revendications 2 et 4, caractérisé en ce que les éléments de détection sont intégrés dans un corps cylindrique en disposant un ou plusieurs éléments de détection piézo-électriques identiques, en forme de disques, sur un axe commun sans pièces d'écartement (3a, 3b,...).

10. Capteur de tension à fibre optique selon la revendication 5, caractérisé en ce que les éléments de détection piézo-électriques (2e, 2f, 2g) sont assemblés bout à bout sans aucune pièce d'écartement.

FIG.1

FIG.2

FIG.3

FIG.4

10